# EUROPÄISCHE PATENTANMELDUNG

(11) **EP 0 990 915 A2**
(43) Veröffentlichungstag der Anmeldung: **05.04.2000**
(21) Anmeldenummer: 99116959.0
(22) Anmeldetag: 27.08.1999
(51) Int. Cl.: G01R 31/04

(54) **Einrichtung zum Prüfen eines mit Kabeln versehenen Steckers**

(30) Priorität: 01.10.1998 DE 29817517 U
(71) Anmelder: TSK Prüfsysteme GmbH, 32457 Porta Westfalica (DE)
(72) Erfinder: Mohme, Heinrich, 32602 Vlotho (DE); Kopietz, Björn, 30173 Hannover (DE)
(74) Vertreter: Stracke, Alexander, Dipl.-Ing.

(57) **Zusammenfassung**

Eine Einrichtung zum Prüfen eines mit Kabeln versehenen Steckers, mit einer in einen Arbeitstisch eingelassenen Kupplungsplatte, die steckerspezifische Teile, wie eine der Kontur des zu prüfenden Steckers angepaßte Steckeraufnahme (3), in deren Bodenbereich angeordnete Prüfnadeln oder dergleichen aufweist, sowie mit steckerunabhängigen Funktionsteilen, wie einem seitlich in die Steckeraufnahme (3) bewegbaren Verriegelungsteil (7), das durch ein Schaltelement (4) betätigbar ist, und Signalleuchten (5), mit denen das Prüfergebnis anzeigbar ist, ist so ausgebildett, daß die steckerunabhängigen Funktionsteile (4, 5, 7) in einem separaten Anschlußteil (2) angeordnet sind, das mit einem die steckerspezifischen Teile aufweisenden Basisteil (1) lösbar verbunden ist.

## Beschreibung

Die vorliegende Erfindung betrifft eine Einrichtung zum Prüfen eines mit Kabeln versehenen Steckers gemäß dem Oberbegriff des Anspruchs 1.

Um zum einen Verwechslungen beim Zusammenstecken von Steckern, die beispielsweise im Automobilbau in einer Vielzahl Verwendung finden, zu verhindern, werden die Stecker in ihrer äußeren Formgebung, insbesondere in ihrer Außenkontur unterschiedlich gestaltet. Zum anderen sind dem Bedarf entsprechend sowohl in ihrer Anzahl wie auch in ihrem Querschnitt von Stecker zu Stecker unterschiedliche Kabeln vorgesehen.

In jedem Fall ist zur Prüfung eines Steckers auf korrekte Verrastung und Kontaktierung der eingestellten Kabel zumindest die in der Kupplungsplatte vorgesehene Steckeraufnahme in ihrer Kontur, aber auch in der Anzahl und Konfiguration der Prüfnadeln dem jeweils zu prüfenden Stecker angepaßt.

Bei den bekannten Einrichtungen sind alle Funktionsteile, also sowohl die steckerspezifischen wie auch die steckerunabhängigen in der Kupplungsplatte angeordnet.

Da jedoch immer nur eine begrenzte Anzahl verschiedener Stecker zu prüfen ist, kommen die in diesem Moment nicht benötigten Kupplungsplatten nicht zum Einsatz, sondern werden gelagert.

Die Herstellung der bekannten Einrichtungen ist vor allem auch deshalb relativ aufwendig und teuer, weil jede einem bestimmten Steckertyp zugeordnete Kupplungsplatte mit allen für die Prüfung notwendigen Teilen ausgestattet ist.

Für den Fall, daß aufgrund der Aufgabe eines Steckertyps die komplette Einrichtung gar nicht mehr zum Einsatz kommt, ist diese komplett zu entsorgen, wobei möglicherweise bestimmte Einzelteile wiederverwendet werden können, wozu jedoch eine aufwendige und teure Demontage erforderlich ist, die sich zumindest aus betriebswirtschaftlicher Sicht vielfach nicht rechnet.

Der vorliegenden Erfindung liegt daher die Aufgabe zugrunde, eine Einrichtung der gattungsgemäßen Art so zu gestalten, daß zumindest Teile davon problemlos austauschbar und wiederverwendbar sind, so daß die Herstellung und Verwendung einer solchen Einrichtung kostengünstiger wird.

Diese Aufgabe wird durch eine Einrichtung gelöst, die die Merkmale des Anspruchs 1 aufweist.

Die Erfindung erlaubt es nun, daß unabhängig von dem jeweiligen zu prüfenden Stecker ein Anschlußteil hergestellt wird, das alle für die Funktionsprüfung des Steckers notwendigen, aber nicht steckerspezifischen Teile aufnimmt. Das heißt, ein derartiges Anschlußteil kann für die Prüfung unterschiedlichster Steckertypen eingesetzt werden.

Die steckerspezifischen Funktionsteile hingegen sind in einem Basisteil angeordnet, das ausschließlich für einen bestimmten Steckertyp hergestellt wird.

Da die Anschlußteile für praktisch alle vorkommenden Basisteile eingesetzt werden können, ist einerseits eine Konfektionierung dieser Anschlußteile möglich, sie sind also beliebig austauschbar, und andererseits kann sich die Anzahl der Anschlußteile auf ein gerade notwendiges Maß reduzieren.

Für den Fall, daß ein Steckertyp nicht mehr hergestellt wird und demzufolge auch nicht mehr geprüft werden muß, ist nun lediglich das die steckerspezifischen Teile aufnehmende Basisteil zu entsorgen, bzw. können die darin befindlichen, steckerspezifisch angeordneten Teile, wie Prüfnadeln, ohne weiteres demontiert und wiederverwendet werden.

Nach einem vorteilhaften Gedanken der Erfindung ist vorgesehen, daß die notwendigen elektrischen Verbindungen zwischen dem Basisteil und dem Anschlußteil durch Steckkontakte hergestellt werden. Das Basisteil und das Anschlußteil werden zweckmäßigerweise miteinander verschraubt, so daß ein einfacher Austausch des Basisteiles möglich ist. Allerdings muß die Anordnung der elektrischen Kontakte einheitlich sein, so daß ein Austausch ohne weiteres möglich ist.

Nach einem weiteren Gedanken der Erfindung ist vorgesehen, daß die Funktionsteile im Anschlußteil, wie ein Schaltelement, ein Steuerventil zur Ansteuerung eines ein Verriegelungsteil bildenden Haltezylinders oder der Signalleuchten auf eine Platine aufgesteckt sind, so daß die bisher üblichen Vorverdrahtungen mit notwendigen Lötarbeiten entfallen.

Dies führt zu einer wesentlichen Vereinfachung der Herstellung bzw. Montage der Einrichtung mit der Folge wesentlich geringerer Herstellungskosten.

Weitere vorteilhafte Ausgestaltungen der Erfindung sind in den Unteransprüchen gekennzeichnet.

Ein Ausführungsbeispiel der Erfindung wird nachfolgend anhand der beigefügten Zeichnung beschrieben.

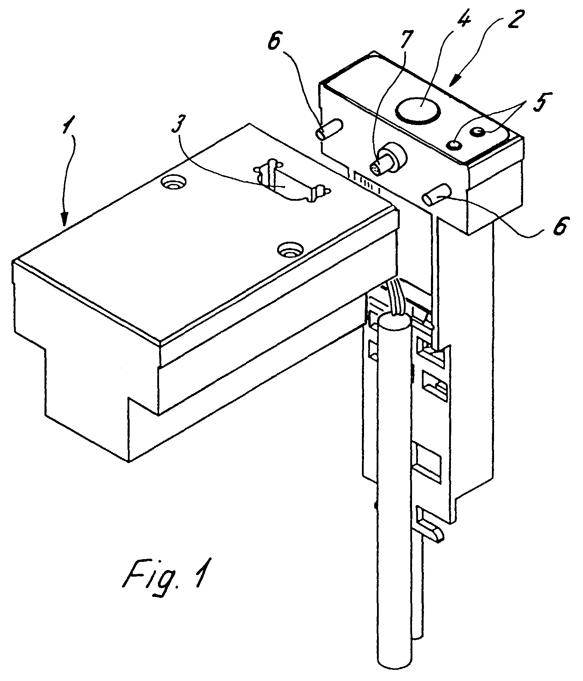

- Die Figur 1: zeigt eine Einrichtung in einer Explosivdarstellung.

In der Figur ist eine Einrichtung zum Prüfen eines mit Kabeln versehenen Steckers auf korrekte Verrastung und Kontaktierung dargestellt. die im wesentlichen aus einem Basisteil 1 und einem damit durch Schrauben 6 lösbar verbundenen Anschlußteil 2 besteht.

Beide Teile sind in einen nicht dargestellten Arbeitstisch eingelassen.

Das Basisteil 1 weist eine Steckeraufnahme 3 auf, die in ihrer Außenkontur einem bestimmten Steckertyp angepaßt ist und in der im Bodenbereich angeordnete, den Anschlußöffnungen des Steckers angepaßte, nicht erkennbare Prüfnadeln angeordnet sind.

Elektrisch sind das Basisteil 1 und das Anschlußteil 2 durch Steckkontakte miteinander verbunden.

In die Steckeraufnahme 3 ist seitlich ein als Haltezylinder ausgebildetes Verriegelungsteil 7 vorgesehen, das über ein Steuerventil, das in dem Anschlußteil angeordnet ist, so steuerbar ist, daß es einen in die Steckeraufnahme 3 eingesetzten Stecker arretiert.

Der Kontakt hierzu wird durch ein Schaltelement in Form eines Drucktastenschalters 4 ausgelöst, der in dem Anschlußteil 2 ebenso angeordnet ist, wie Signalleuchten 5, durch die das Prüfergebnis angezeigt wird.

## Patentansprüche

1. Einrichtung zum Prüfen eines mit Kabeln versehenen Steckers, mit einer in einen Arbeitstisch eingelassenen Kupplungsplatte, die steckerspezifische Teile, wie eine der Kontur des zu prüfenden Steckers angepaßte Steckeraufnahme (3), in deren Bodenbereich angeordnete Prüfnadeln oder dergleichen aufweist, sowie mit steckerunabhängigen Funktionsteilen, wie einem seitlich in die Steckeraufnahme (3) bewegbaren Verriegelungsteil (7), das durch ein Schaltelement (4) betätigbar ist, und Signalleuchten (5), mit denen das Prüfergebnis anzeigbar ist, **dadurch gekennzeichnet, daß** die steckerunabhängigen Funktionsteile (4, 5, 7) in einem separaten Anschlußteil (2) angeordnet sind, das mit einem die steckerspezifischen Teile aufweisenden Basisteil (1) lösbar verbunden ist.

2. Einrichtung nach Anspruch 1, **dadurch gekennzeichnet, daß** das Basisteil (1) und das Anschlußteil (2) elektrisch durch Steckkontakte miteinander verbunden sind.

3. Einrichtung nach Anspruch 1, **dadurch gekennzeichnet, daß** das Basisteil (1) und das Anschlußteil (2) miteinander verschraubt sind.

4. Einrichtung nach Anspruch 1, **dadurch gekennzeichnet, daß** die steckerunabhängigen Funktionsteile des Anschlußteiles (2) auf eine darin angeordnete Platine aufgesteckt sind.
